# EUROPEAN PATENT APPLICATION

(11) **EP 2 947 779 A1**
(43) Date of publication of application: **25.11.2015**
(21) Application number: 14305774.3
(22) Date of filing: 23.05.2014
(51) Int. Cl.: H03M 7/46, H03M 5/14, H03M 7/14

(54) **Method and apparatus for storing information units in nucleic acid molecules and nucleic acid storage system**

(71) Applicant: Thomson Licensing, 92130 Issy-les-Moulineaux (FR)
(72) Inventor: Chen, Xiaoming, 30165 Hannover (DE); Blawat, Meinolf, 30659 Hannover (DE); Huetter, Ingo, 30982 Pattensen (DE); Gaedke, Klaus, 30659 Hannover (DE)
(74) Representative: Rittner, Karsten

(57) **Abstract**

A nucleic acid storage system (20), a method and an apparatus for storing information units in nucleic acid molecules are described. A coding scheme is applied which avoids generation of self-reverse complementary nucleic acid strands. A first code generator (28) provides first code words, wherein the reverse complementary words also belong to the first code. A second code generator (30) provides second code words, wherein the reverse complementary words also belong to the second code. No code word exists within the first and second code which belongs to both codes. An information encoder (32) encodes the information units using first code words. A multiplexer (34) generates multiplexed code word sequences wherein after a predefined amount of first code words one second code word is inserted. A nucleic acid synthesizer (36) synthesizes nucleic acid molecules wherein a sequence of nucleotides is arranged to correspond to the multiplexed code word sequence.

## Description

### FIELD OF THE INVENTION

The invention relates to a method and an apparatus for storing information and to a data storage system. In particular, the invention relates to a method and an apparatus for storing information units in nucleic acid molecules and a nucleic acid storage system, for example a DNA storage system.

### BACKGROUND OF THE INVENTION

A nucleic acid is a polymeric macromolecule and consists of a sequence of monomers known as nucleotides. Each nucleotide consists of a sugar component, a phosphate group and a nitrogenous base or nucleobase. Nucleic acid molecules where the sugar component of the nucleotides is deoxyribose are DNA (deoxyribonucleic acid) molecules, whereas nucleic acid molecules where the sugar component of the nucleotides is ribose are referred to as RNA (ribonucleic acid) molecules. DNA and RNA are biopolymers appearing in living organisms.

Nucleic acid molecules are assembled as chains or strands of nucleotides. Naturally occurring DNA molecules usually form double-stranded helices, while RNA molecules are usually single-stranded. However, nucleic acid molecules can be generated artificially and their chain structure can be used for encoding any kind of user data. For storing data in synthesized, i.e. artificially created, DNA or RNA, usually short, single-stranded DNA or RNA fragments (oligonucleotides, short: oligos) are generated. With these nucleic acid fragments, a storage system can be realized. Such a nucleic acid storage system is a data storage system wherein data are stored in nucleic acid molecules.

In this context, the terms "nucleic acid fragment", "oligonucleotide" and "oligo" are used interchangeably and refer to a short nucleic acid strand. A "section" or a "segment" of a strand refers to a subset of the strand, i.e. one or a sequence of more or even all of the contained nucleotides. The term "short" in this context is to be understood as short in comparison to a length of natural DNA which encodes genetic instructions used by living organisms and which may consist of millions of nucleotides. Synthesized oligos may contain more than one, for example more than hundred or several thousands of nucleotides.

DNA strands consist of four different nucleotides identified by their respective nucleobases or nitrogenous bases, namely, Adenine, Thymine, Cytosine and Guanine, which are denoted shortly as A, T, C and G, respectively. RNA strands also consist of four different nucleotides identified by their respective nucleobases, namely, Adenine, Uracil, Cytosine and Guanine, which are denoted shortly as A, U, C and G, respectively.

Oligonucleotide synthesis or nucleic acid synthesis is the chemical synthesis of oligos with a defined chemical structure, i.e., with a defined sequence of nucleotides, which can be generated by a nucleic acid synthesizer. In other words, a synthesizer can be used to generate artificial, synthetic fragments of nucleic acid molecules, for example DNA fragments, i.e. DNA oligos. This technology enables a provision of data storage systems wherein a write process is based on the creation of nucleic acid fragments as sequences of nucleotides which encode information to be stored.

Digital information storage in synthesized DNA or RNA may provide a high-capacity, low-maintenance information storage.

A system based on storing information in sequences of nucleotides may be considered as a special case of an information transmission system wherein a mapping of information bits to different nucleotides is interpreted as modulation. Accordingly, A, T , C and G for DNA and, respectively, A, U, C and G for RNA can be regarded as modulation symbols, where the symbol alphabet size is 4.

The synthesized nucleic acid fragments can be stored. The information can be retrieved from the stored nucleic acid fragments by sequencing of the nucleic acid fragments, which is a process of determining the order of nucleotides within the particular nucleic acid fragment. For correct sequencing of nucleic acid fragments by a sequencer, the synthesized nucleic acid fragments, i.e., oligos or nucleic acid strands, are first amplified, i.e., replicated multiple times, for example by means of polymerase chain reaction. The sequencing can be interpreted as a read process. Then the read out order of nucleotides is processed or decoded to recover the original information stored in the nucleic acid fragment.

Nucleobases tend to connect to their complementary counterparts via hydrogen bonds. For example, natural DNA usually shows a double helix structure, where A of one strand is connected to T of the other strand, and, similarly, C tends to connect to G. In this context, A and T, as well as C and G, are called complementary. Correspondingly, A with U and G with C form pairs of complementary RNA bases.

Two sequences of nucleotides are considered "reverse complementary" to each other, if an antiparallel alignment of the nucleotide sequences results in the nucleobases at each position being complementary to their counterparts.

Complementarity does not only occur between separate strands of DNA or RNA. It is also possible for a sequence of nucleotides to have internal or self-reverse complementarity. This may result in a folded configuration where the strand or sequence binds to itself and may, for example, form hairpins or loops. A nucleic acid fragment is considered self-reverse complementary, if the fragment is equal to itself after complementary, reversing steps. For example, a DNA fragment AATCTAGATT is self-reverse complementary:

| | |
|---|---|
| Original DNA fragment: | AATCTAGATT |
| Complementary: | TTAGATCTAA |
| Order reversing: | AATCTAGATT |

A repetition of this short DNA fragment or a concatenation with other short self-reverse complementary DNA fragments results in a long self-reverse complementary DNA fragment. While a single short self-complementary segment may be acceptable, for example, long self-reverse complementary DNA fragments may not be readily sequenced, indicating that corresponding DNA strands will possibly not appear in readouts, which prohibits or at least hinders later decoding of the information encoded in the strand.

Therefore, it is preferred to avoid synthesis of long self-reverse complementary nucleic acid fragments.

### SUMMARY OF THE INVENTION

It is an object of the present invention to provide an improved solution for storing information units in nucleotide sequences, which allows for a reliable retrieval of the stored information units.

According to an aspect of the invention, a method for storing a set of information units in nucleic acid molecules comprises
- providing a plurality of first code words, wherein reverse complementary code words of corresponding first code words also belong to the plurality of first code words;
- providing a plurality of second code words, wherein reverse complementary code words of corresponding second code words also belong to the plurality of second code words and wherein no code word exists in the plurality of first code words and the plurality of second code words which belongs both to the plurality of first code words and also to the plurality of second code words;
- encoding the set of information units using a subset of the plurality of first code words;
- generating at least one multiplexed code word sequence from one or more first code words of said subset and one or more second code words, wherein after a predefined amount of first code words one second code word is inserted; and
- synthesizing at least one nucleic acid molecule comprising a segment wherein a sequence of nucleotides is arranged to correspond to the at least one multiplexed code word sequence.

Accordingly, an apparatus for storing a set of information units in nucleic acid molecules comprises
- a first code word generator unit configured to provide a plurality of first code words, wherein reverse complementary code words of corresponding first code words also belong to the plurality of first code words;
- a second code word generator unit configured to provide a plurality of second code words, wherein reverse complementary code words of corresponding second code words also belong to the plurality of second code words and wherein no code word exists in the plurality of first code words and the plurality of second code words which belongs both to the plurality of first code words and also to the plurality of second code words;
- an information encoder unit configured to encode the set of information units using a subset of the plurality of first code words;
- a multiplexer unit configured to generate at least one multiplexed code word sequence from one or more first code words of said subset and one or more second code words, wherein after a predefined amount of first code words at least one second code word is inserted; and
- a nucleic acid synthesizer unit configured to synthesize at least one nucleic acid molecule comprising a segment wherein a sequence of nucleotides is arranged to correspond to the at least one multiplexed code word sequence.

Further, a nucleic acid storage system comprises
- an apparatus for storing a set of information units in nucleic acid molecules as described above;
- a storage unit arranged to store nucleic acid molecules;
- a nucleic acid sequencer unit configured to sequence said nucleic acid molecules and generate at least one multiplexed code word sequence from the sequenced nucleic acid molecules; and
- a demultiplexer unit configured to extract code words of the first code from the generated at least one multiplexed code word sequence. An information decoder may then be used to extract the encoded information units.

The term "set" refers to a collection of distinct objects, e.g. code words, and comprises one or more, potentially all, of the objects. The term "subset" of a plurality of code words refers to one or more, potentially all, code words in the plurality of code words. The subset of the plurality of first code words may comprise all first code words. However, not all first code words may be used for encoding the information units. An information unit refers to a quantum of information such as a bit or a plurality of bits, for example a byte.

The solution according to the aspect of the invention provides a switch coding scheme for generating the code word sequence to be used for synthesizing a corresponding sequence of nucleotides. Two codes with specific properties are multiplexed. The first code is used to encode information to be stored in nucleic acid fragments, while the second code is used to avoid an occurrence of long self-reverse complementary nucleic acid fragments. The first and second codes provide the following properties: (i) The reverse complementary word of a code word in a code still belongs to the code. (ii) There is no common code word between the two codes. Property (i) means that if a nucleic acid fragment belongs to a code, its reverse complementary counterpart also belongs to the code. Property (ii) guarantees that a code word in one code is not the reverse, complementary counterpart of any code word in the other code. Preferably, the reverse complementary of a code word is different to the code word, i.e., not a self-reverse complementary code word.

The shown solution at least has the effect that the nucleic acid strands resulting from multiplexing code words of the two different codes will not be self-reverse complementary and will not or only very rarely contain short self-complementary sections. Since synthesized nucleic acid segments are now usually not self-reverse complementary, the reliability of their sequencing is improved, allowing provision of a reliable system for storing information units in nucleic acid molecules.

In one embodiment at least one nucleic acid molecule is a DNA (Deoxyribonucleic acid) molecule. The generated nucleic acid molecule could also be an RNA (Ribonucleic acid) molecule. However, due to its chemical structure DNA may be more stable. For example, it may be less prone to hydrolysis than RNA. Therefore, longer and more stable nucleotide sequences may be synthesized, allowing a more efficient long-term storage of the encoded information.

In one embodiment each of the first and second code words is formed by a set of quaternary symbols. This allows a direct correspondence or mapping of used symbols to DNA or RNA nucleotides and enables a more efficient coding than, for example, a mapping of binary symbols 0 and 1 to two respective of the four different nucleotides.

In one embodiment the synthesizing of at least one nucleic acid molecule comprises synthesizing nucleic acid fragments for the subset of the plurality of first code words and the plurality of second code words and concatenating the nucleic acid fragments during the generation of at least one multiplexed code word sequence. In other words, the generation of a code word sequence and its synthesis as a DNA or RNA fragment are not performed in two separate, consecutive steps, but short nucleic acid fragments are generated for the generated code words, and their concatenation to correspond to the multiplexed code word sequence is performed as a separate step of processing after the multiplexed code word sequence has been generated. In this context, a code refers to a set of short nucleic acid fragments. This enables a production of short nucleic acid fragments in a first stage even before the encoding of the information units into nucleotide sequences, whereas the later encoding comprises a concatenation of the short fragments to longer nucleotide sequences according to generated multiplexed code word sequences. This may shorten a duration of the final synthesis stage and may allow improved traceability of errors during the production process, as well as an easy change of the predefined amount of first code words to be concatenated before a second code word is inserted. For example, the predefined amount of first code words can be reduced in the event of sequencing problems. Or the synthesis may be accelerated by parallel usage of more than one synthesizer unit, e.g. one for generating nucleic acid fragments corresponding to first code words, one for generating nucleic acid fragments corresponding to second code words and another one for concatenating the produced fragments according to the code word sequence.

In one embodiment only a subset of the plurality of second code words is used for the generation of at least one multiplexed code word sequence, wherein the reverse complementary code words of corresponding first code words do not belong to said subset. The reverse complementary code words of the second code are not used for generating any multiplexed code word sequence. Hence, any code word sequence retrieved by sequencing stored nucleic acid fragments can be easily identified as erroneous in case it contains any reverse complementary of one of the second code words. Furthermore, a case of self-reverse complementarity of longer code word sequences can be avoided, wherein a second code word and its reverse complementary code word are alternately inserted between first code words.

In one embodiment the set of information units is encoded using an error detection code prior to encoding the set of information units using the subset of the plurality of first code words. The error detection code may be understood as any coding to detect at least one error in the encoded information units. Any error correction code is regarded as a special case of an error detection code. The error detection code may be applied on a per information unit basis or for multiple information units or the whole set of information units. In order to retrieve the information encoded in the stored nucleic acid molecules, a sequencer performs a read process wherein the order of the nucleotides within the nucleic acid molecules is determined. This determination process comprises an amplification, i.e., a replication of the stored nucleic acid fragments, e.g., by several orders of magnitude, for example by applying polymerase chain reaction. A decision on the actually read sequence can be implemented, for example, by means of a majority decision between the multiple read sequences. This usage of an error detection code or an error correction code, for example, allows accepting more errors and, thereby, reducing the sequencing effort, for example by reducing the amplification factor.

In one embodiment another set of information units is encoded using the plurality of second code words. In this manner, the overall coding efficiency may be further increased.

While not explicitly described, the present embodiments may be employed in any combination or sub-combination.

### BRIEF DESCRIPTION OF THE DRAWINGS

- FIG. 1: schematically illustrates a method for storing a set of information units in nucleic acid molecules according to an embodiment of the invention;
- FIG. 2: schematically illustrates a nucleic acid storage system comprising an apparatus for storing a set of information units in nucleic acid molecules according to an embodiment of the invention; and
- FIG. 3: schematically illustrates an example of a multiplexed code word sequence.

### DETAILED DESCRIPTION OF PREFERED EMBODIMENTS

For a better understanding, the invention will now be explained in more detail in the following description with reference to the drawings. It is understood that the invention is not limited to these exemplary embodiments and that specified features can also expediently be combined and/or modified without departing from the scope of the present invention as defined in the appended claims.

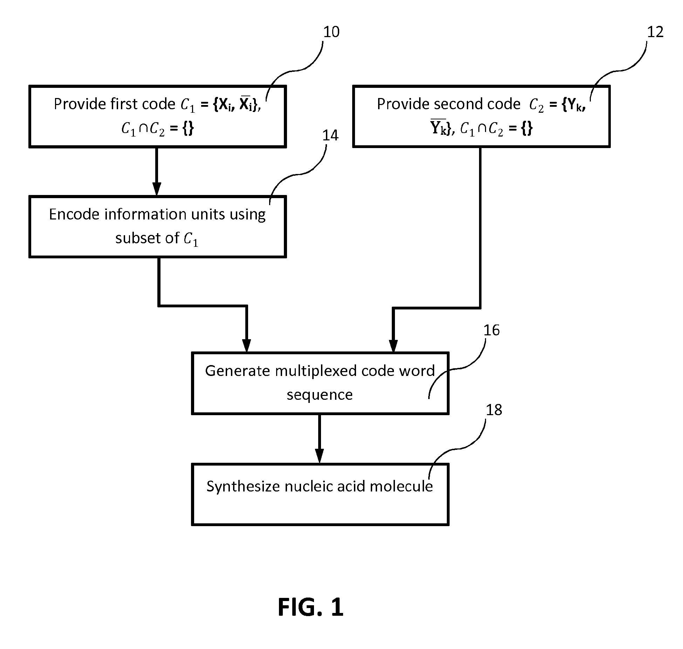

Referring to FIG. 1, a method for storing a set of information units in nucleic acid molecules according to an embodiment of the invention is schematically shown. "Information units" refer to any digital representation of user data to be stored, e.g. binary encoded bitstreams.

In a first step, a first code *C*₁, i.e. a plurality of first code words, is provided 10, wherein the reverse complementary code words X̅ᵢ of corresponding first code words Xᵢ also belong to the plurality of first code words. A first code word consists of a short sequence of code symbols, for example five quaternary code symbols. The provision of the code comprises the provision of a code book mapping binary encoded information units to quaternary first code words. An information unit may, for example, consist of a group of bits, for example 8 bits corresponding to a byte, or more than 8 bits, additionally containing at least one bit dedicated to error detection encoding of the information.

In a second step, which may be carried out either concurrently with, before or after the first step, a second code *C*₂ consisting of a plurality of second code words is provided 12 wherein the reverse complementary code words Y̅ₖ of corresponding second code words Yₖ also belong to the plurality of second code words. No code word exists in the plurality of first code words and the plurality of second code words which belongs to both the first code and also to the second code, i.e., there is no common code word between the two codes.

In a third step, the set of information units is encoded 14 using a subset of the plurality of first code words. The set of information units encoded in the third step may already be encoded using an error detection code. The set of information units may correspond to any digital, for example binary encoded, user data such as textual, audio, image or video data.

In a fourth step, at least one multiplexed code word sequence is generated 16 from one or more first code words of the subset of first code words which have been used to encode the user data information units, and one or more second code words. After a predefined amount of first code words one second code word is inserted. The predefined amount may, for example, be 1 or 2. While the first code words carry the encoded information to be stored, the second code words are used to avoid that long self-reverse complementary nucleic acid fragments are created by a concatenation of first and second code words. How often and at which positions to insert code words of *C*₂ depends on an acceptable length of a self-reverse complementary nucleic acid fragment before causing problems during sequencing. Many more than one multiplexed code word sequence may be generated, depending on the amount of information units to be stored and the technically feasible length of a sequence of nucleotides the used synthesizer will be able to create.

In a fifth step, at least one nucleic acid molecule, for example at least one DNA molecule, comprising a segment wherein a sequence of nucleotides is arranged to correspond to the at least one multiplexed code word sequence is synthesized 18. Many more than one nucleic acid molecules may be generated. The amount of nucleic acid molecules or oligos generated or synthesized by a synthesizer corresponds to the amount of generated multiplexed code word sequences. At least one nucleic acid molecule is synthesized for each multiplexed code word sequence. However, multiple nucleic acid molecules may be generated for each or a selected, for example high-priority, subset of the multiplexed code word sequences.

The synthesized nucleic acid molecules carry the information encoded by the succession of the nucleotides forming the nucleic acid molecules. These molecules can be stored and the information can be retrieved by reading the sequence of nucleotides using a sequencer, demultiplexing the retrieved multiplexed code word sequences by removing the second code words and decoding the extracted first code words.

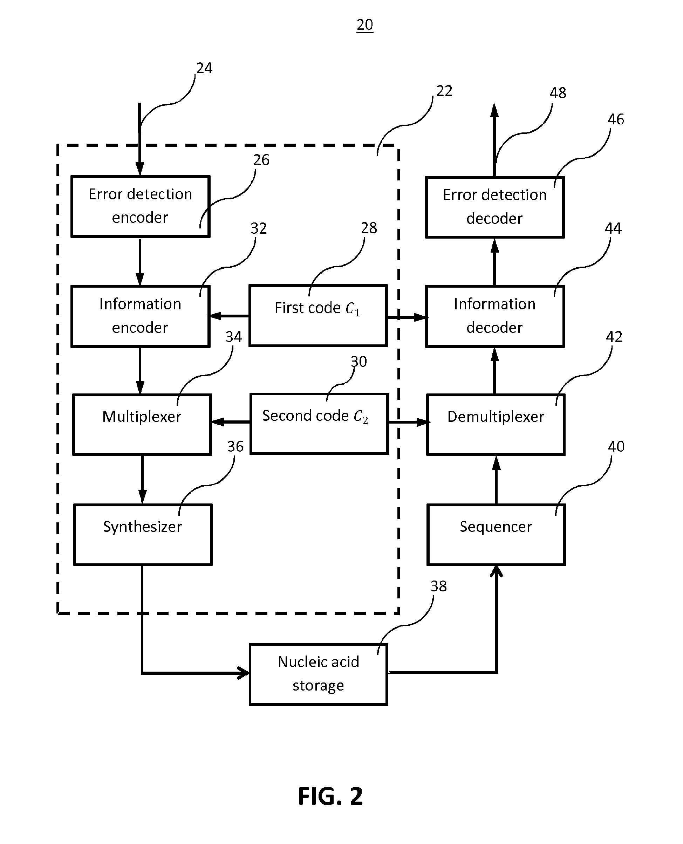

Referring to FIG. 2, a nucleic acid storage system 20 comprising an apparatus 22 for storing information units in nucleic acid molecules according to one embodiment of the invention is schematically illustrated. The described system and apparatus allow implementing the advantages and characteristics of the described method as part of the nucleic acid storage system and, respectively, the apparatus for storing a set of information units in nucleic acid molecules.

The shown storage system 20 may, for example, be a DNA storage system, i.e., a system for storing information in synthesized DNA strands and retrieving the stored information by sequencing the stored synthetic DNA strands.

The apparatus 22 for storing information units in nucleic acid molecules has an input 24 for receiving information units, e.g., sets of information bits of user data. The information bits are provided to an error detection encoder unit 26 which is configured to apply an additional error detection code. The error detection code could be an error correction code arranged to enable detection or, respectively, correction of errors within the information bits once they are retrieved after storage of the information. The error detection encoded information bits are provided to an information encoder unit 32 arranged to encode the provided bits according to a first code *C*₁ provided by a first code word generator unit 28. The code words may be generated on request by the information encoder unit 32 or may be generated in advance and provided via, for example, a code book table or memory containing the generated first code words. The first code *C*₁ contains first code words, wherein the reverse complementary code words of corresponding first code words also belong to the first code.

An output of the information encoder unit 32 is connected to a multiplexer unit 34. The multiplexer unit 34 is also connected to receive second code words of a second code *C*₂ provided by a second code word generator unit 30. The second code words may be generated on request by the multiplexer unit 34 or may be generated in advance and provided via, for example, a second code book table or memory containing the generated second code words. The second code *C*₂ contains second code words, wherein the reverse complementary code words of corresponding second code words also belong to the second code, whereas none of the first code words belongs to the second code and vice versa.

The multiplexer unit 34 multiplexes code words from *C*₁ and *C*₂ to generate a code word sequence which can be synthesized as a nucleic acid strand which is not self-reverse complementary.

In order to avoid even short sections of multiplexed first and second code words which are self-reverse complementary, a corresponding reverse complementary code word of a second code word used for multiplexing is not used within a same code word sequence.

A nucleic acid synthesizer unit 36, which may be, for example, a DNA synthesizer unit or an RNA synthesizer unit, receives the multiplexed code word sequences. The nucleic acid synthesizer unit 36 synthesizes at least one nucleic acid molecule comprising at least a segment wherein a sequence of nucleotides is arranged to correspond to the at least one multiplexed code word sequence. Each of the synthesized nucleic acid molecules consists of a sequence or chain of nucleotides generated by a bio-chemical process and represents an oligo or nucleic acid fragment wherein the sequence or cascade of the nucleotides encodes the multiplexed code word sequence. In a DNA storage system, short DNA fragments are generated.

In the shown nucleic acid storage system 20, the generated nucleic acid fragments are stored, either as solid matter or dissolved in a liquid, in a nucleic acid storage 38 as a container. The characteristics of the nucleic acid storage 38 may depend on the amount of stored data and an expected time before a readout of the data will take place.

The stored data can be read out using a sequencer unit 40 which receives the stored nucleic acid fragments from the nucleic acid storage 38, determines the sequences of nucleotides of the nucleic acid fragments and provides multiplexed code word sequences corresponding to the read sequences of nucleotides to a demultiplexer unit 42.

The demultiplexer unit 42 is configured to detect second code words and extract code words of the first code from the read multiplexed code word sequences. For this task, as shown, the demultiplexer unit 42 may be provided directly with the second code from the second code word generator unit 30 of the apparatus 22. In other embodiments the demultiplexer unit 42 may, for example, receive the second code words from a different code word generator connected to the demultiplexer unit 42 and configured to generate the same second code words, or the second code words may be provided as a code book stored in a memory connected to or contained in the demultiplexer unit 42.

The remaining first code words are provided to an input of an information decoder unit 44 to retrieve the error detection encoded information units. For this task, as shown, the information decoder unit 44 may be provided directly with the first code from the first code word generator unit 28 of the apparatus 22. In other embodiments the information decoder unit 44 may, for example, receive the first code words from a different code word generator connected to the information decoder unit 44 and configured to generate the same first code words, or the first code words may be provided as a code book stored in a memory connected to or contained in the information decoder unit 44 or the information encoder unit 44 will be able to perform the decoding without a code book.

The stored information bits are finally recovered by an error detection decoder unit 46 using error detection decoding and provided to an output 48.

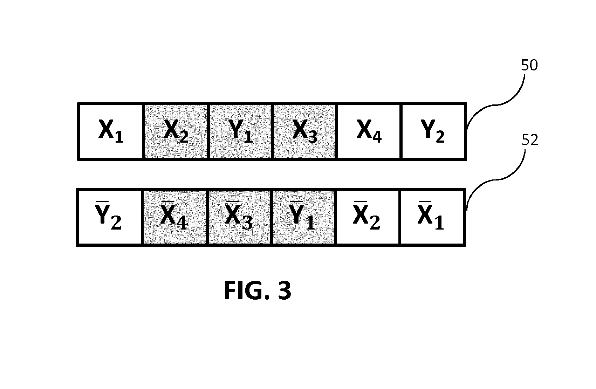

The switch coding scheme applied by the apparatus 22 for storing information units in nucleic acid molecules is now further explained with reference to FIG. 3.

FIG. 3 schematically illustrates an example of a multiplexed code word sequence for generating a nucleic acid fragment, e.g. a DNA fragment, which is not self-reverse complementary. Multiplexed code word sequence 50 is the original fragment obtained by inserting code words of *C*₂ into a sequence of code words of *C*₁ which encode information bits. Multiplexed code word sequence 52 is the reverse complementary counterpart of the multiplexed code word sequence 50 for generating the original nucleic acid fragment.

As shown, information bits are encoded in code words of *C*₁ denoted as X₁, X₂, X₃, X₄. To avoid self-reverse complementarity, code words from *C*₂, denoted as Y₁, Y₂, are inserted. After concatenation, the multiplexed code word sequence 50 for synthesizing a nucleic acid fragment is obtained as X₁, X₂, Y₁, X₃, X₄, Y₂. Its reverse complementary counterpart 52 is shown as Y̅₂, X̅₄, X̅₃, Y̅₁, X̅₂, X̅₁. X̅ and Y̅ are used to denote the reverse complementary words for X and Y, respectively.

For example, if Y is a code word **AG** consisting of two code symbols **A** and **G** corresponding to, for example, a short DNA nucleotide sequence containing nucleobases Adenine and Guanine, then Y equals to the reverse complementary code word **CT** consisting of two code symbols **C** and **T** corresponding to a nucleotide sequence containing nucleobases Cytosine (complementary to Guanine) and Thymine (complementary to Adenine).

Since Y̅₂ does not belong to the first code *C*₁, X₁ shown in multiplexed code word sequence 50 cannot be equal to Y̅₂ shown in the reverse complementary multiplexed code word sequence 52, i.e., X₁ ≠ Y̅₂. Similarly, Y₁ ≠ X̅₃, X₃ ≠ Y̅₁ Y₂ ≠ X̅₁. Consequently, the nucleic acid fragment created corresponding to multiplexed code word sequence 50 will not be self-reverse complementary.

Moreover, as long as one complete code word from code *C*₂ is contained in a multiplexed code word sequence corresponding to a portion of a nucleic acid fragment, this portion is also not self-reverse complementary within the nucleic acid fragment. As an example, the shadowed regions containing a sequence of code words X₂ (chosen from *C*₁), Y₁ (chosen from *C*₂) and X₃ (chosen from *C*₁) and, respectively, X̅₄, X̅₃ and Y̅₁ shown in FIG. 3 cannot be reverse complementary to each other since Y₁ is not complementary to X̅₃. Moreover, no region within multiplexed code word sequence 50 that contains a sequence of code words chosen from multiplexed code word sequence 50 will be reverse complementary to its corresponding counterpart within the reverse complementary code word sequence 52 if the region contains at least one complete code word from code *C*₂.

In another example, *C*₁ = **{AC, AG, AT, GC, GT, CT, GA, TC}** and *C*₂ = {**AA**, **CC**, **CA**, **GG**, **CG**, **TA**, **TG**, **TT**} are two codes which fulfill the conditions that the reverse complementary word of a code word in a code still belongs to the code, and that there is no common code word between the two codes. Let 101,111,110,001 be units of information bits to be stored in a DNA strand to be synthesized. At first, the units of information bits are encoded by *C*₁ as first code words **CT, TC, GA** and **AG.** Cascading the code words results in a code word sequence **CTTCGAAG,** which is self-reverse complementary. To avoid later sequencing problems when using this self-reverse complementary code word sequence for generating a DNA fragment, the multiplexer unit inserts code word **AA** taken from code *C*₂ after the first two code words **CTTC** and after the second two code words **GAAG.** Thus, the final multiplexed code word sequence for synthesizing the DNA fragment becomes **CTTCAAGAAGAA,** which is not self-reverse complementary any more.

With the proposed solution, self-reverse nucleic acid strands can be avoided and problems with sequencing synthesized nucleic acid strands can be reduced, thereby improving their suitability to serve as a bio-chemical storage for any kind of user data.

As will be appreciated by one skilled in the art, aspects of the present principles can be embodied as a system, method or computer readable medium. Accordingly, aspects of the present principles can take the form of a hardware embodiment, a software embodiment or an embodiment combining software and hardware aspects. Furthermore, aspects of the present principles can take the form of a computer readable storage medium. Any combination of one or more computer readable storage medium(s) may be utilized.

Apart from the bio-chemical processing of synthesizing and sequencing nucleic acid strands, aspects of the invention may, for example, at least partly be implemented in a computer program comprising code portions for performing steps of the method according to an embodiment of the invention when run on a programmable apparatus or enabling a programmable apparatus to perform functions of an apparatus or a system according to an embodiment of the invention.

Unless stated otherwise, terms such as "first" and "second" are used to arbitrarily distinguish between the elements the terms describe and are not necessarily intended to indicate temporal or other prioritization of the elements.

Any connection shown may be a direct connection or an indirect connection. Further, those skilled in the art will recognize that the boundaries between logic blocks are merely illustrative and that alternative embodiments may merge logic blocks or impose an alternate decomposition of functionality upon various logic blocks.

## Claims

1. A method for storing a set of information units in nucleic acid molecules, **comprising**
- providing (10) a plurality of first code words, wherein reverse complementary code words of corresponding first code words also belong to the plurality of first code words;
- providing (12) a plurality of second code words, wherein reverse complementary code words of corresponding second code words also belong to the plurality of second code words and wherein no code word exists in the plurality of first code words and the plurality of second code words which belongs both to the plurality of first code words and also to the plurality of second code words;
- encoding (14) the set of information units using a subset of the plurality of first code words;
- generating (16) at least one multiplexed code word sequence from one or more first code words of said subset and one or more second code words, wherein after a predefined amount of first code words one second code word is inserted; and
- synthesizing (18) at least one nucleic acid molecule comprising a segment wherein a sequence of nucleotides is arranged to correspond to the at least one multiplexed code word sequence.

2. The method according to claim 1, **wherein** said at least one nucleic acid molecule is a Deoxyribonucleic acid molecule.

3. The method according to claim 1 or claim 2, **wherein** each of the first and second code words is formed by a set of quaternary symbols.

4. The method according to one of the preceding claims, **wherein** said synthesizing (18) at least one nucleic acid molecule comprises synthesizing nucleic acid fragments for said subset of said plurality of first code words and said plurality of second code words and concatenating said nucleic acid fragments during said generating at least one multiplexed code word sequence.

5. The method according to one of the preceding claims, **wherein** only a subset of said plurality of second code words is used for said generating (16) at least one multiplexed code word sequence, wherein the reverse complementary code words of corresponding first code words do not belong to said subset.

6. The method according to one of the preceding claims, **comprising** encoding said set of information units using an error detection code prior to said encoding the set of information units using said subset of the plurality of first code words.

7. The method according to one of the preceding claims, **comprising** encoding another set of information units using the plurality of second code words.

8. An apparatus (22) for storing a set of information units in nucleic acid molecules, **comprising**
- a first code word generator unit (28) configured to provide a plurality of first code words, wherein reverse complementary code words of corresponding first code words also belong to the plurality of first code words;
- a second code word generator unit (30) configured to provide a plurality of second code words, wherein reverse complementary code word of corresponding second code words also belong to the plurality of second code words and wherein no code word exists in the plurality of first code words and the plurality of second code words which belongs both to the plurality of first code words and also to the plurality of second code words;
- an information encoder unit (32) configured to encode the set of information units using a subset of the plurality of first code words;
- a multiplexer unit (34) configured to generate at least one multiplexed code word sequence from one or more first code words of said subset and one or more second code words, wherein after a predefined amount of first code words one second code word is inserted; and
- a nucleic acid synthesizer unit (36) configured to synthesize at least one nucleic acid molecule comprising a segment wherein a sequence of nucleotides is arranged to correspond to the at least one multiplexed code word sequence.

9. The apparatus (22) according to claim 8, **wherein** said at least one nucleic acid molecule is a Deoxyribonucleic acid molecule.

10. The apparatus (22) according to claim 8 or claim 9, **wherein** each of the first and second code words is formed by a set of quaternary symbols.

11. The apparatus (22) according to one of claims 8 to 10, **wherein** said nucleic acid synthesizer unit (36) is configured to synthesize nucleic acid fragments for said subset of said plurality of first code words and said plurality of second code words and to concatenate said nucleic acid fragments depending on a generation of at least one multiplexed code word sequence by said multiplexer unit (34).

12. The apparatus (22) according to one of claims 8 to 11, **wherein** said multiplexer unit (34) is configured to use only a subset of said plurality of second code words to generate said at least one multiplexed code word sequence, wherein the reverse complementary code words of corresponding first code words do not belong to said subset.

13. The apparatus (22) according to one of claims 8 to 12, **comprising** an error detection encoding unit configured to encode said set of information units using an error detection code prior to encoding the set of information units using said subset of the plurality of first code words by said information encoder unit (32).

14. The apparatus (22) according to one of claims 8 to 13, **wherein** the information encoder unit (32) is configured to encode another set of information units using the plurality of second code words.

15. A nucleic acid storage system **comprising**
- an apparatus (22) as claimed in one of claims 8 to 14;
- a nucleic acid storage unit (38) arranged to store nucleic acid molecules;
- a nucleic acid sequencer unit (40) configured to sequence said nucleic acid molecules and generate at least one multiplexed code word sequence from said sequenced nucleic acid molecules; and
- a demultiplexer unit (42) arranged to extract code words of the first code from the generated at least one multiplexed code word sequence.
